# EUROPEAN PATENT APPLICATION

(11) **EP 4 787 398 A1**
(43) Date of publication of application: **05.08.2026**
(21) Application number: 23938691.5
(22) Date of filing: 12.12.2023
(51) Int. Cl.: H01B 1/22

(54) **CONDUCTIVE PASTE COMPOSITION, SOLAR CELL PREPARATION METHOD, AND SOLAR CELL**

(30) Priority: 27.09.2023 CN 202311265866
(71) Applicant: Solamet Electronic Materials (Dongguan) Co., Ltd., Dongguang, Guangdong 523077 (CN); Solamet Materials Science Co., Ltd., Huzhou, Zhejiang 313300 (CN)
(72) Inventor: GUO, Qijie, Hainesport, NJ 08036 (US); CHANG, Wei Hsuan, 324020 Taiwan (CN); YIN, Chichum, 330720 Taoyuan City Taiwan (CN)
(74) Representative: Murgitroyd & Company
(86) International application number: PCT/CN2023/138183
(87) International publication number: WO 2025/065903

(57) **Abstract**

The invention discloses a conductive paste composition, a preparation method of a solar cell and the solar cell. The conductive paste composition comprises 0.5 wt % to 4 wt % of glass frit, 80 wt % to 92 wt % of conductive component, and 7 wt % to 16 wt % of organic medium. The glass frit comprises oxides. In terms of molar percentages of the oxides, the glass frit includes 20 mol % to 50 mol % of B₂O₃, and the glass frit further comprises 15 mol % to 50 mol % of PbO, or 15 mol % to 50 mol % of Bi₂O₃, or 15 mol % to 50 mol % of mixture of PbO and Bi₂O₃. The ratio of a sum of the cation content of PbO and the cation content of the Bi₂O₃ to the cation content of B₂O₃ is 0.30 to 1.25. After being sintered, the conductive paste composition can etch a passivation layer on the surface of a battery and meanwhile achieve the effect of low recombination of carriers.

## Description

### CROSS-REFERENCE TO RELATED APPLICATIONS

This application claims priority to Chinese Patent Application No. 202311265866.0, filed with the China National Intellectual Property Administration on September 27, 2023 and entitled "CONDUCTIVE PASTE COMPOSITION, SOLAR CELL PREPARATION METHOD, AND SOLAR CELL", which is incorporated herein by reference in its entirety.

### TECHNICAL FIELD

This application pertains to the technical field of photovoltaic devices, and more specifically, to a conductive paste composition, a solar cell preparation method, and a solar cell.

### BACKGROUND

Metallization is an important step in a photovoltaic solar cell production process, to effectively extract photo-generated carriers to achieve high power conversion efficiency. Screen printing is currently the most preferred method for metallization. For an N-type solar cell, such as an n-TOPCon cell that includes a tunnel oxide passivated contact structure, a metallization paste (silver-aluminum paste or Ag-Al paste) that includes silver powder and aluminum powder is generally used and sintered at a high temperature to achieve effective metallization on the p side (or a p-type doped layer) of the solar cell. During the sintering process, the glass frit in the silver-aluminum paste etches and opens the passivation stack which typically includes layers of SiNₓ, SiNOₓ, and AlOₓ, allowing the metals in the paste to react with the underlying p-type doped layer to form silver-aluminum spike microstructures to achieve good ohmic contact.

### TECHNICAL PROBLEM

The silver-aluminum paste can form a low resistivity ohmic contact with the p-type doped layer, but relatively high carrier recombination causes an open-circuit voltage loss and an efficiency loss of a cell, which are important factors that affect the power conversion efficiency of the N-type solar cell. In addition, etching or damage of passivation film by the glass frit in the silver-aluminum paste during high temperature sintering further increases a recombination loss.

### SUMMARY

An embodiment of this application provides a conductive paste composition, where the conductive paste composition includes 0.5 wt % to 4 wt % of glass frit, 80 wt % to 92 wt % of conductive component, and 7 wt % to 16 wt % of organic medium in terms of weight percentage of the conductive paste composition.

The glass frit includes oxides. In terms of mole percentages of the oxides, the glass frit includes 20 mol % to 50 mol % of B₂O₃; and the glass frit further includes 15 mol % to 50 mol % of PbO, or 15 mol % to 50 mol % of Bi₂O₃, or 15 mol % to 50 mol % of mixture of PbO and Bi₂O₃.

A ratio of the sum of the cation contents of PbO and Bi₂O₃ to the cation content of B₂O₃ is 0.30 to 1.25.

In some embodiments, in terms of the mole percentages of the oxides, the glass frit further includes a first additive, a content of the first additive is less than or equal to 18 mol %, and the first additive is any one or more selected from Li₂O, Al₂O₃, ZnO, SiO₂, SeO₂, and TeO₂.

In some embodiments, the first additive satisfies at least one of the following conditions in terms of the mole percentages of the oxides:
(a) the first additive includes Li₂O, and a content of the Li₂O is less than or equal to 15 mol %;
(b) the first additive includes Al₂O₃, and a content of the Al₂O₃ is less than or equal to 10 mol %;
(c) the first additive includes ZnO, and a content of the ZnO is less than or equal to 18 mol %;
(d) the first additive includes SiO₂, and a content of the SiO₂ is less than or equal to 15 mol %;
(e) the first additive includes SeO₂, and a content of the SeO₂ is less than or equal to 15 mol %; or
(f) the first additive includes TeO₂, and a content of the TeO₂ is less than or equal to 15 mol %.

In some embodiments, in terms of the mole percentages of the oxides, the glass frit further includes: 0 to 15 mol % of Li₂O; 0 to 10 mol % of Al₂O₃; 0 to 18 mol % of ZnO; and 0 to 15 mol % of SiO₂.

In some embodiments, in terms of the mole percentages of the oxides, the glass frit further includes a second additive, a content of the second additive is less than or equal to 5 mol %, and the second additive is selected from any one or more of AgO₂, Ag₂O, AgO, Na₂O, K₂O, MgO, CaO, and BaO.

In some embodiments, the conductive paste composition further includes a filler less than or equal to 1 wt % in terms of the weight percentage of the conductive paste composition. The filler includes at least one of aluminum powder, silicon powder, or aluminum-silicon alloy powder.

In some embodiments, the weight percentage of the filler in the conductive paste composition is greater than 0 and less than or equal to 1 wt %.

In some embodiments, Dᵥ50 of the filler is 1 µm to 4 µm, and Dᵥ50 is a particle size corresponding to the cumulative volume percentage of the filler reaching 50%.

In some embodiments, the conductive component is selected from any one of silver, silver alloy, silver oxide, and silver salt, or a mixture of the combinations thereof.

In some embodiments, a first conductive structure is formed on a solar cell, the solar cell comprises a substrate and a passivation layer at least located on one side of the substrate. During the process the solar cell is sintered, the conductive paste composition penetrates the passivation layer to form the first conductive structure.

In some embodiments, the substrate includes an n-type doped semiconductor substrate.

In some embodiments, this application further provides a solar cell preparation method, including the following steps:
providing a baseplate, where the baseplate includes a substrate, a p-type doped layer, and a passivation layer, and the p-type doped layer is located between the substrate and the passivation layer;
applying the conductive paste composition onto the passivation layer;
sintering the baseplate covered with the conductive paste composition, so that the conductive paste composition etches the passivation layer in a sintering process to form a first conductive structure; and
performing laser enhancement contact optimization on the baseplate to obtain the solar cell.

In some embodiments, the application of the conductive paste composition onto the passivation layer includes:
applying the conductive paste composition to at least a part of a surface of the passivation layer in a patterned form.

In some embodiments, the step of performing laser enhancement contact optimization on the baseplate further includes:
applying a reverse voltage bias to the baseplate, and simultaneously performing laser scanning on the baseplate, to generate induced current in the first conductive structure.

In some embodiments, the preparation method meets at least one of the following conditions:
(g) the solar cell has a breakdown voltage, and the reverse voltage is less than the breakdown voltage;
(h) the laser scanning lasts for 1 ms to 100 ms; or
(i) the induced current is 100 A to 1000 A.

In some embodiments, this application further provides a solar cell, where the solar cell includes a first conductive structure made from the conductive paste composition.

In some embodiments, this application further provides a solar cell, and the solar cell is prepared by using the preparation method.

In some embodiments, the solar cell is a solar cell containing a tunnel oxide passivated contact structure.

### TECHNICAL EFFECT

The conductive paste composition of the application may be applied for the metallization of the p side of the solar cell. After being sintered, the conductive paste composition may etch the passivation layer on the surface of the cell without causing a high carrier recombination loss. By limiting the cation ratio of Pb+Bi to B in the glass frit the corrosivity of the glass frit is further improved wherein the excessive recombination loss caused when the conductive paste composition etches the passivation layer can be reduced.

According to the solar cell preparation method provided in this application, proper etching of the passivation layer is achieved after the used conductive paste composition is sintered which reduces the carrier recombination loss. Further, with reference to the laser enhancement contact optimization technology, a large quantity of carriers generated by the laser are guided into the first conductive structure by applying a reverse voltage bias, and induced current is generated. Energy generated by the induced current improves the contact and the contact uniformity of the first conductive structure. Together with higher open circuit voltage as a result of the reduced carrier recombination loss by the used conductive paste composition, the conversion efficiency of the solar cell can be significantly improved.

### BRIEF DESCRIPTION OF THE DRAWINGS

To describe technical solutions in embodiments of this application more clearly, the following briefly introduces the accompanying drawings for describing the embodiments. It is clear that the accompanying drawings in the following descriptions show merely some embodiments of this application, and a person skilled in the art may still derive other drawings from these accompanying drawings without creative efforts.

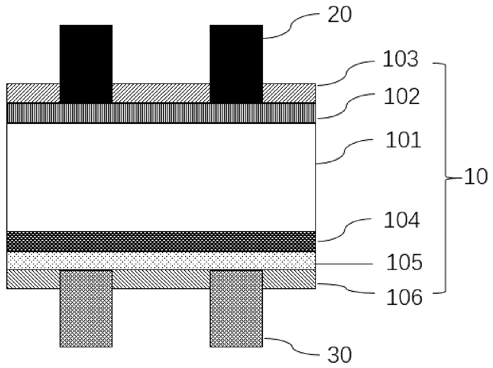

FIG. 1 is a cross-sectional view of a solar cell according to an embodiment of this application.

Reference numerals: 10-baseplate, 20-First conductive structure, 30-Second conductive structure, 101-substrate, 102-p-type doped layer, 103-Passivation layer, 104-tunnel oxide passivation layer, 105-n⁺ polycrystalline silicon layer, 106-Second passivation layer

### IMPLEMENTATIONS OF THIS APPLICATION

The following clearly and completely describes the technical solutions in the embodiments of this application with reference to the accompanying drawing of the embodiments of this application. It is clear that the described embodiments are merely some samples, not all of embodiments of this application. All other embodiments obtained by a person skilled in the art based on the embodiments of this application without creative efforts shall fall within the protection scope of this application.

In the description of this application, it should be understood that a direction or a location relationship indicated by the terms "up", "down", "top", "bottom", "inside", or "outside" is based on a direction or a location relationship shown in accompanying drawings, is merely for the ease of description and simplification of this application, and is not intended to indicate or imply that referred apparatus or element must have a specific direction, or be constructed or operated in a specific direction. Therefore, it should not be understood as a limitation of this application. In the description of this application, "a plurality of" means two or more, and "at least one" means one, two, or more, unless otherwise specifically limited.

Metallization is an important step in a photovoltaic solar cell production process to effectively extract photo-generated carriers to achieve high optical-to-electrical conversion efficiency. Screen printing is currently the most preferred method for applying metallization paste. For an N-type solar cell, such as a n-TOPCon solar cell that includes a tunnel oxide passivated contact structure a metallization paste (silver-aluminum paste or Ag-Al paste) that includes silver powder and aluminum powder is generally applied and sintered at a high temperature to achieve metallization effect on the p side (or a p-type doped layer) of the solar cell. The glass frit in the silver-aluminum paste etches and opens a passivation film including SiNₓ, SiNOₓ, and AlOₓ during the sintering process, allowing the metal in the paste to react with the p-type doped layer to form silver-aluminum spike structures with good ohmic contact. Although the silver-aluminum paste can form a low resistivity ohmic contact with the p-type doped layer, the relatively high carrier recombination (carrier recombination loss) causes open-circuit voltage loss and efficiency loss, hence affect power conversion efficiency of the solar cell. In addition, since surface passivation of the baseplate has a significant effect on carrier recombination, etching or damage of the passivation film by the glass frit in the silver-aluminum paste during high temperature sintering further increases the recombination loss.

In view of foregoing, it is necessary to provide a conductive paste composition, a solar cell preparation method, a solar cell, and especially a conductive paste applicable to the p side, so as to achieve the effect of low carrier recombination loss, and enable the metallization method to obtain higher open circuit voltage and hence higher photovoltaic power conversion efficiency.

Some embodiments of this application provide a conductive paste composition that is used to form a low carrier recombination and a low-resistance electrical contact with a p-type doped layer of a solar cell.

According to the conductive paste composition provided in some embodiments of this application, the conductive paste composition includes 0.5 wt % to 4 wt % of glass frit, 80 wt % to 92 wt % of conductive component, and 7 wt % to 16 wt % of organic medium in terms of a weight percentage of the conductive paste composition. The glass frit includes oxides. In terms of mole percentages of the oxides, the glass frit includes 20 mol % to 50 mol % of B₂O₃; and the glass frit further includes 15 mol % to 50 mol % of PbO, or 15 mol % to 50 mol % of Bi₂O₃, or 15 mol % to 50 mol % of mixture of PbO and Bi₂O₃. A ratio of a sum of the cation content of the PbO and Bi₂O₃ to the cation content of the B₂O₃ is 0.30 to 1.25.

The glass frit and the conductive component are used as solid components in the conductive paste composition, the organic medium is used to disperse the solid components in the conductive paste composition and provides printing performance. A sum of weight percentages of all components in the conductive paste composition is 100%. A cation content refers to a quantity or proportion of cations in a chemical substance. In a chemical formula, a cation is usually a positively charged ion.

The following describes each component individually.

### Glass Frit

In some embodiments, a glass frit refers to a composition containing one or more types of anions and cations. The glass frit can melt and flow during heating. The glass frit may be partially or completely amorphous or partially crystalline.

In some embodiments, the glass frit may be understood as a composition having oxide components, and the weight percentage of the content of the glass frit in the conductive paste composition is 0.5 wt % to 4 wt %. In other embodiments, the weight percentage of the amount of the glass frit in the conductive paste composition may be 1.0 wt % to 3.8 wt %, or may be 1.5 wt % to 3.5 wt %, or may be 2.0 wt % to 3.0 wt %, or may be 2.2 wt % to 2.8 wt %. It may be understood that adjustment in the amount of the glass frit in the conductive paste composition needs to ensure that the sum of weight percentages of all the components in the conductive paste composition is 100%. The composition of the glass frit directly affects its melting, fluidity and etching ability. Therefore, the composition of the glass frit needs to be well balanced to achieve an excellent effect in carrier recombination.

In some embodiments, in terms of the mole percentages of the oxides, the glass frit contains at least the following components: 15 mol % to 50 mol % of PbO and/or Bi₂O₃, and 20 mol % to 50 mol % of B₂O₃. In the following description, unless otherwise specified, "mol %" of the content of each component of the glass frit means mole percentage in terms of oxides. In addition, 15 mol % to 50 mol % may indicate that a corresponding range is greater than or equal to 15 mol % and less than or equal to 50 mol %, and the same applies to others.

In some embodiments, in a further example, the glass frit includes 20 mol % to 40 mol % of PbO and/or Bi₂O₃, and 30 mol % to 40 mol % of B₂O₃ in terms of the mole percentages of the oxides.

In some embodiments, PbO, Bi₂O₃ or a combination thereof may form a glass with a low melting point and good fluidity. Either PbO and BiO₂ can etch the passivation layer during sintering and have a function of lowering the glass melting point and improving the fluidity of glass.

In some embodiments, B₂O₃ acts as a glass former, and may form glass with a low melting point and provide good fluidity. B₂O₃ may form a network structure, which helps stabilize the glass, and improve the bonding ability of the melted glass with the baseplate.

In some embodiments, a ratio of the total cation content of PbO and Bi₂O₃ to the cation content of B₂O₃ in the glass frit is 0.30 to 1.25. For example, the ratio may be any value of 0.30, 0.32, 0.34, 0.36, 0.38, 0.40, 0.45, 0.50, 0.55, 0.60, 0.65, 0.70, 0.75, 0.80, 0.85, 0.90, 0.95, 1.00, 1.05, 1.10, 1.15, 1.20, 1.21, 1.22, 1.23, 1.24, or 1.25, or a range between any two of the foregoing values. By limiting the cation ratio of Pb+Bi to B, the etching ability of the glass frit can be improved. Because the etching ability of PbO is stronger than that of Bi₂O_{3,} part of PbO in the composition of the glass frit may be replaced with Bi₂O₃ to adjust the etching ability of the glass frit. When the foregoing cation ratio range is satisfied, the etching property of the glass frit can be controlled by adjusting the cation ratio of Pb+Bi to B, to obtain the effect of low carrier recombination in order to significantly improve the open circuit voltage and hence photovoltaic power conversion efficiency.

In some embodiments, the glass frit further includes a first additive of 18 mol % or less in terms of the mole percentages of the oxides, and the first additive is selected from any one or more of Li₂O, Al₂O₃, ZnO, SiO₂, SeO₂, and TeO₂. In a further example, the glass frit further includes 3 mol % to 15 mol % of the first additive in terms of the mole percentages of the oxides. In a further example, the glass frit further includes 6 mol % to 10 mol % of the first additive in terms of the mole percentages of the oxides.

In some embodiments, the first additive is used to modify the glass frit, and may further include a glass former or a glass modifier. In a glass frit preparation process, the glass former is used to form an initial network structure of the glass. When the additional glass former is added into the glass network structure, the initial network structure formed by the glass former is changed, and original properties of the glass are changed. The content of each component in the first additive may be adjusted based on desired glass property and performance.

In some embodiments, TeO₂ or SeO₂ may be used as the glass former to increase fluidity . The content of SeO₂ in the glass frit is 15 mol % or less in terms of the mole percentages of the oxides. The content of TeO₂ in the glass frit is 15 mol % or less in terms of the mole percentages of the oxides. In a further example, the content of SeO₂ in the glass frit is 5 mol % or more and 10 mol % or less in terms of the mole percentages of the oxides. In a further example, the content of TeO₂ or SeO₂ in the glass frit is 5 mol % or more and 7.5 mol % or less in terms of the mole percentages of the oxides.

In some embodiments, Li₂O is used as a glass modifier. Appropriate amount of Li₂O can increase the glass fluidity. As Li₂O has a corrosion effect, the amount of Li₂O needs to be controlled within a specific range. The content of Li₂O in the glass frit is 15 mol % or less in terms of the mole percentages of the oxides. In a further example, the content of Li₂O in the glass frit is 5 mol % or more and 10 mol % or less in terms of the mole percentages of the oxides. In the foregoing range, fluidity and etching ability of the glass can be improved.

In some embodiments, Al₂O₃ as a glass former can stabilize the glass phase, increase the glass melting point, and reduce fluidity. The content of Al₂O₃ in the glass frit is 10 mol % or less in terms of the mole percentages of the oxides. In a further example, the content of Al₂O₃ in the glass frit is 3 mol % or more and 7 mol % or less in terms of the mole percentages of the oxides. Within the above range, an increase in the glass transition temperature can be minimized.

In some embodiments, ZnO is used as a glass modifier, and proper addition of ZnO may improve electrical performance. The content of ZnO in the glass frit is 18 mol % or less in terms of the mole percentages of the oxides. In a further example, the content of ZnO in the glass frit is 6 mol % or more and 12 mol % or less in terms of the mole percentages of the oxides. In the foregoing range, melting and fusing of the glass frit can be promoted to facilitate glass preparation.

In some embodiments, SiO₂ is used as a glass former, and proper addition of SiO₂ can stabilize the glass phase, increase the glass melting point, and reduce fluidity. SiO₂ may further improve stability of the glass frit. The content of SiO₂ in the glass frit is 15 mol % or less in terms of the mole percentages of the oxides. In a further example, the content of SiO₂ in the glass frit is 3 mol % or more and 10 mol % or less in terms of the mole percentages of the oxides. Within the foregoing range, the glass transition temperature and glass fluidity during sintering can be adjusted to control etching property during sintering.

In some embodiments, in terms of the mole percentages of the oxides, the glass frit includes 15 mol % to 50 mol % of PbO and/or Bi₂O₃, 20 mol % to 50 mol % of B₂O₃, 0 to 15 mol % of Li₂O, 0 to 10 mol % of Al₂O₃, 0 to 18 mol % of ZnO, and 0 to 15 mol % of SiO₂.

In some embodiments, in terms of the mole percentages of the oxides, the glass frit includes 15 mol % to 50 mol % of PbO and/or Bi₂O₃, 20 mol % to 50 mol % of B₂O₃, 0 to 15 mol % of Li₂O, 0 to 10 mol % of Al₂O₃, 0 to 18 mol % of ZnO, 0 to 15 mol % of SiO₂, and 0 to 15 mol % of SeO₂ or TeO₂.

In some embodiments, the glass frit further includes a second additive at an amount of 5 mol % or less in terms of the mole percentages of the oxides, and the second additive is any one or more selected from AgO₂, Ag₂O, AgO, Na₂O, K₂O, MgO, CaO, and BaO. It may be understood that the second additive, as glass modifiers, may further change and adjust the melting point and fluidity of the glass frit in cooperation with the first additive.

### Conductive Component

In some embodiments, the conductive component is used to provide conductivity of the conductive paste composition, and the conductive component in this embodiment may use, without being particularly limited, metal powder commonly used in an electrode formed on a baseplate such as a semiconductor baseplate. Exemplary metals include but are not limited to silver, gold, copper, nickel, palladium, platinum, aluminum, and their alloys and mixtures. Alternatively, the conductive component consists essentially of silver due to its excellent processability and high conductivity.

In some embodiments, the weight percentage of the content of the conductive component in the conductive paste composition is 80 wt % to 92 wt %. In some other embodiments, the weight percentage of the content of the conductive component in the conductive paste composition may be 82 wt % to 90 wt %, or may be 85 wt % to 88 wt %, or may further be 86 wt % to 87 wt %. It may be understood that adjustment in the amount of the conductive component in the conductive paste composition needs to ensure that the sum of the weight percentages of all the components in the conductive paste composition is 100%. The conductive component is configured to provide conductivity of the electrode after the solar cell is formed.

In some embodiments, the conductive component in the conductive paste composition of this application may be metal powder. Alternatively, the conductive component may be a mixture of two or more such metals or alloys. The metal may further be provided by a metal oxide or metal salt which can thermally decompose to form the corresponding metal(s). When the metal powder is silver powder, it may be understood that when the metal powder is silver powder, it includes an alloy of silver, a silver oxide or silver salt o, and a mixture thereof, and may further include silver oxide such as Ag₂O or AgO, or silver salts such as AgCl, AgNO₃, AgOOCCH₃ (silver acetate), AgOOCF₃ (silver trifluoroacetate), Ag₃PO₄ (silver orthophosphate), or a mixture thereof.

In some embodiments, the conductive component may be provided as finely dispersed particles in a form such as powder form, flake form, spherical form, rod form, granular form, nodular form, layered or coated form, other irregular forms, or a combination thereof.

In some embodiments, the median particle size of the conductive component is in the range of 0.5 µm to 3.5 µm. In a further example, the conductive component uses spherical silver powder with a median particle size of 1 µm to 3 µm. In a further example, the conductive component uses spherical silver powder with a median particle size of 1.5 µm to 2.5 µm. In a further example, the conductive component uses spherical silver powder with a median particle size of about 2 µm. A main function of silver powder is to form densely sintered silver electrode after sintering in order to obtain good electrical conductivity.

### Organic Medium

In some embodiments, in addition to the solid components include the conductive component and the glass frit, the organic medium is used as a liquid phase in the conductive paste composition to disperse the foregoing solid components, to form a paste with a specific viscosity and rheology. The organic medium enables the foregoing conductive component and glass frit to be dispersed and stable over extended time, and further enable the conductive paste composition to be applied on the passivation layer of the baseplate with an expected pattern by screen printing.

In some embodiments, the organic medium may include a polymer and an organic solvent. The polymer may include cellulose, resin, esters, and the like. The cellulose includes cellulose resins such as methylcellulose, ethyl cellulose, carboxymethyl cellulose, hydroxyethyl cellulose, benzyl cellulose, propyl cellulose, nitrocellulose, or a mixture thereof. The resin includes wood rosin, phenolic resin, acrylic resin, or a mixture thereof. The esters include polymethacrylate of lower alcohols, or the like. The organic solvent may include terpineol, diethylene glycol butyl ether acetate, diethylene glycol ethyl ether acetate, propylene glycol diacetate, α-terpene, β-terpene, dibutyl phthalate, butylcarbitol, butylcarbitol acetate, hexanediol, or the like.

In some embodiments, the viscosity and rheology of the organic medium make it suitable for printing methods, including but not limited to screen printing. The organic medium may further include another auxiliary agent such as a non-ionic surfactant, a thixotropic agent, a dispersant, or a rheological agent, to adapt to different requirements of the organic medium.

### Filler

In some embodiments, the weight percentage of a content of the filler in the conductive paste composition is 0 to 1 wt%, and the filler is at least one selected from aluminum powder, silicon powder, or aluminum-silicon alloy powder.

In some embodiments, unlike aluminum powder added to a silver paste (thus known as aluminum-silver paste) commercially available for n-TOPCon solar cells to obtain ohmic contact with the p-doped layer, the aluminum powder added as a filler in this embodiment is to modulate the etching ability of glass frit to obtain a higher open circuit voltage. It may be understood that the increase in open circuit voltage is obtained because of the addition amount of aluminum powder. This is because by adding a small amount of aluminum powder into the conductive paste composition, during the high-temperature sintering process, a small amount of aluminum or alumina can be incorporated into the molten glass frit. The increase in the aluminum oxide content of the molten glass frit results in reduced fluidity and etching ability, and further result in less damage to the passivation film. Therefore, the effect of the addition of a small amount of aluminum powder to the conductive paste composition will result in an increase in the open-circuit voltage due to a lower recombination. However, the amount of aluminum powder added into the conductive paste composition has to be limited as an excessive amount of aluminum or alumina incorporated into the molten glass frit during sintering greatly reduces its etching ability, which might result in a negative impact on the filling factor.

In a further example, the weight percentage of the content of the filler in the conductive paste composition is 0 to 0.75 wt %.

In a further example, the weight percentage of the content of the filler in the conductive paste composition is any one of 0.25 wt %, 0.50 wt %, 0.75 wt %, and 1.0 wt % or is in a range between any two thereof.

In some embodiments, Dᵥ50 of the filler is 1 µm to 4 µm, and Dᵥ50 is refers to a particle size corresponding to the cumulative volume percentage of the filler reaching 50%. In a further example, Dᵥ50 of the filler is 1 µm to 3 µm. In a further example, Dᵥ50 of the filler is about 2 µm.

In some embodiments, the glass powder may be produced by using a method commonly used in the glass manufacturing field. For example, according to the glass frit composition and proportion described in the embodiment, the oxides are batched, mixed, added to a crucible (such as platinum or ceramic crucible), heated to a peak temperature (for example, 800°C to 1400°C) and kept for a period of time to melt the oxides together. The molten material may then be quenched in any suitable manner, including but not limited to, passing it between reverse rotating stainless steel rollers to form a 0.25 mm to 0.50 mm thick sheet, pouring it on a thick stainless steel plate or pouring it into water. Then, the obtained glass frit is milled by using a common milling technology to form a powder with a particle size Dᵥ50 of 0.5 µm to 2 µm.

In some embodiments, the method for preparing the conductive paste composition may include: performing batching, stirring, and dispersing based on the paste components described in the embodiments, dispersing and milling the paste composition to a fineness of less than 10 µm by using a three-roller mill, and then performing further filtering. The amount of glass frit and aluminum powder added in some embodiments may be different, which can be replaced with an equal amount of silver powder, and the amount of others such as the organic medium remains unchanged. The adjustment of the percentages of the glass frit, the conductive component, the organic medium, and the filler needs to ensure that the sum of the weight percentages of the components in the conductive paste composition is 100%.

In some embodiments, the conductive paste composition in this embodiment is used to form the first conductive structure 20 in a solar cell. The solar cell includes a substrate 101, and the substrate 101 has a main surface and at least one passivation layer 103 disposed on the main surface. The conductive paste composition can etch the passivation layer 103 when sintering, to form the first conductive structure 20.

It may be understood that an electrical connection with low carrier recombination can be formed between the first conductive structure 20 and the p-type semiconductor in the substrate 101. In an example, the p-type semiconductor may be a p-type doped layer, and the substrate 101 may be an n-type doped semiconductor substrate. In addition, in the TOPCon solar cell, the p-type doped layer is also referred to as a p-type emitter.

### Solar Cell

As shown in FIG. 1, some embodiments of this application provide a solar cell. The solar cell includes a tunnel oxide passivated contact structure (Tunnel Oxide Passivated Contacts), and the above-mentioned conductive paste composition is used during preparation of the solar cell.

In some embodiments, the solar cell including the tunnel oxide passivated contact structure is referred to as a TOPCon solar cell (Tunnel Oxide Passivated Contact Solar Cell). This solar cell uses a tunnel oxide layer as a charge transport channel and a surface passivation layer to improve efficiency and performance of the solar cell. TOPCon solar cell has low electron reflection and surface recombination, as well as a high phototoltaic conversion efficiency and a low electronic defect.

In some embodiments, the TOPCon solar cell includes a baseplate 10 and a first conductive structure 20, and the baseplate 10 includes a substrate 101, a p-type doped layer 102 formed on a side of the base101, and a passivation layer 103 formed on the side of the p-type doped layer 102 that is away from the substrate 101. FIG. 1 is used as an example. The substrate 101 is located in a middle of the TOPCon solar cell, and may be an n-type doped semiconductor substrate. The p-type doped layer 102 is located on the front side of the n-type doped semiconductor substrate, and the passivation layer 103 is located on the surface of the p-type doped layer 102. The conductive structure 20 penetrates at least a part of the passivation layer 103 and forms an electrical connection with the p-type doped layer 102.

In some embodiments, as shown in FIG. 1, the baseplate 10 further includes: a tunnel oxide passivation layer 104 located on a back side of the n-type doped semiconductor substrate; an n⁺ polycrystalline silicon layer 105 located on the side of the tunnel oxide passivation layer 104 that is away from the n-type doped semiconductor substrate; a second passivation layer 106 deposited on the side of the n⁺ polycrystalline silicon layer 105 that is away from the tunnel oxide passivation layer 104.

In some embodiments, as shown in FIG. 13, the TOPCon solar cell further includes a second conductive structure 30. The second conductive structure 30 penetrates at least a part of the second passivation layer 106 and forms an electrical connection with the n⁺ polycrystalline silicon layer 105.

In some embodiments, the front side is a light-receiving side of the solar cell, and is also the working surface of the solar cell. The back side is the back side of the solar cell, and usually does not receive sunlight directly.

In some embodiments, the first tunnel oxide passivation layer 104 and the n⁺ polycrystalline silicon layer 105 are formed by a tunnel oxide layer passivation contact method.

In some embodiments, the first conductive structure 20 is formed by the conductive paste composition in this embodiment. The conductive paste composition is applied to at least a part of the surface of the passivation layer 103 in a desired pattern. In a subsequent sintering process, the conductive paste composition penetrates the passivation layer 103 to obtain the first conductive structure 20, which is electrically connected to the p-type doping layer 102 and has low carrier recombination.

In some embodiments, the second conductive structure 30 may utilize a silver metallization paste that is commercially available for P-type or N-type crystalline silicon solar cells, such as a silver paste containing Pb-Te-O glass powder. The conductive paste composition is applied to at least a part of the surface of the second passivation layer 106 in a desired pattern. In a sintering process, the silver paste containing Pb-Te-O glass powder etches and penetrates the second passivation layer 106, to form electrical contact with the n⁺ polycrystalline silicon layer 105.

An embodiment of this application provides a solar cell preparation method, including the following steps:
(1) providing a baseplate 10, the baseplate 10 includes a substrate 101, a p-type doped layer 102 formed on a side of the substrate 101, and a passivation layer 103 formed on the side of the p-type doped layer 102 that is away from the substrate 101. A trivalent element (such as boron or gallium) is doped on the front side of the substrate 101, to form the p-type doped layer 102 on the front side of the n-type doped semiconductor substrate. The passivation layer 103 is deposited on the surface of the p-type doped layer 102 by using a deposition method.
(2) applying the conductive paste composition provided in this embodiment on the passivation layer 103. Specifically, the conductive paste composition is applied to at least a part of a surface of the passivation layer 103 in a desired pattern such as by screen printing. It may be understood that the conductive paste composition in this embodiment is used as the finger grid on the P side of the solar cell that includes the tunnel oxide passivation contact structure. Four screen printing machines are commonly used to apply metallization pastes for TOPCON solar cells and respectively corresponds to the rear busbars, rear finger grid, front busbars, and front finger grid. The conductive paste composition in this embodiment is used for the finger grid on the P side, which is generally the front finger grid on the fourth screen printer.
(3) sintering the baseplate 10 and the conductive paste composition, so that the conductive paste composition etches the passivation layer 103 to form a first conductive structure 20. In addition, preparation of a second conductive structure 30 is the same as preparation of the first conductive structure 20.
(4) performing laser enhancement contact optimization on the baseplate 10 to obtain a solar cell.

The sequence numbers of the foregoing steps are not considered as a limitation on a sequence of the steps.

In some embodiments, in step (4), laser enhancement contact optimization is a method for improving electrical contact of the metallization paste by using a laser in a manufacturing process of a solar cell. A basic principle of the laser enhancement contact optimization technology is that a large quantity of carriers generated by a laser are guided through the sintered finger grid by applied voltage bias, wherein the heat generated by the current from the carrier flow improves contact resistivity and contact uniformity. Thereby improving overall contact performance, reducing contact defects, and improving the efficiency and reliability of the solar cell. In this technology, the amount of carrier injection can be controlled by using parameters such as laser power and laser scan rate to achieve better contact uniformity and optimize improvement effect.

In some embodiments, the step of performing laser enhancement contact optimization on the baseplate 10 further includes: applying a reverse voltage to the baseplate 10 while performing laser scanning on the baseplate 10 to generate induced current in the first conductive structure 20. The laser enhancement contact optimization technology can be used to process the conductive structure to lower contact resistance, and help to increase the open circuit voltage and improve the efficiency.

In some embodiments, the reverse voltage is less than the breakdown voltage of the solar cell.

In some embodiments, the laser scanning lasts for 1 ms to 100 ms. For example, the laser scanning period may be any one of 1 ms, 2 ms, 3 ms, 5 ms, 10 ms, 20 ms, 30 ms, 40 ms, 50 ms, 60 ms, 70 ms, 80 ms, 90 ms, or 100 ms, or a range between any two of the foregoing values.

In some embodiments, the induced current is 100 A to 1000 A. For example, the induced current may be any one of 100 A, 150 A, 200 A, 250 A, 300 A, 350 A, 400 A, 450 A, 500 A, 550 A, 600 A, 650 A, 700 A, 750 A, 800 A, 850 A, 900 A, 950 A, or 1000 A, or a range between any two of the foregoing values.

The following further describes the technical solutions of this application with reference to specific examples.

Contents of components in glass frits in example 1 to example 13 and contents of components in glass frits in Comparative example 1 to Comparative example 4 are shown in Table 1. The sum of percentages of components in the glass frit for the examples as well as that for the comparative examples are 100%. Each value in Table 1 is a mole percentage (mol %). In Comparative examples 1 and 2, the cation ratio of (Pb+Bi)/B is not in the range of 0.30 to 1.25. The content of the first additive TeO₂ added in Comparative examples 3 and 4 is too high.

**Table 1**

| | PbO | Bi₂O₃ | B₂O₃ | SeO₂ | TeO₂ | Li₂O | Al₂O₃ | SiO₂ | ZnO | CaO | BaO | Cation ratio of (Pb+Bi)/B |
|---|---|---|---|---|---|---|---|---|---|---|---|---|
| Example 1 | 40 | / | 40 | / | / | / | 1 | 13 | 6 | / | / | 0.50 |
| Example 2 | 20 | 10 | 50 | / | / | / | 1 | 13 | 6 | / | / | 0.40 |
| Example 3 | / | 30 | 50 | / | / | / | 1 | 13 | 6 | / | / | 0.60 |
| Example 4 | / | 15 | 50 | / | / | 15 | 1 | 13 | 6 | / | / | 0.30 |
| Example 5 | 50 | / | 20 | / | / | / | 3 | 15 | 12 | / | / | 1.25 |
| Example 6 | 40 | / | 25 | / | / | / | 7 | 10 | 18 | / | / | 0.80 |
| Example 7 | 45 | / | 30 | / | / | / | 10 | 3 | 12 | / | / | 0.75 |
| Example 8 | 20 | 10 | 50 | / | / | / | 1 | 8 | 6 | 5 | / | 0.40 |
| Example 9 | 20 | 10 | 50 | / | / | / | 1 | 8 | 6 | / | 5 | 0.40 |
| Example 10 | 30 | / | 35 | 15 | / | / | 2 | 12 | 6 | / | // | 0.43 |
| Example 11 | 30 | / | 42.5 | / | 7.5 | / | 2 | 12 | 6 | / | / | 0.35 |
| Example 12 | 30 | / | 35 | / | 15 | / | 2 | 12 | 6 | / | / | 0.43 |
| Example 13 | 20 | 10 | 35 | / | 15 | / | 2 | 12 | 6 | / | / | 0.57 |
| Comparative example 1 | 60 | / | 20 | / | / | / | 1 | 6 | 13 | / | / | 1.50 |
| Comparative example 2 | 20 | / | 60 | / | / | / | 1 | 13 | 6 | / | / | 0.17 |
| Comparative example 3 | 30 | / | 27.5 | / | 22.5 | / | 2 | 12 | 6 | / | / | 0.55 |
| Comparative example 4 | 30 | / | 20 | / | 30 | / | 2 | 12 | 6 | / | / | 0.75 |

In Table 1, conductive paste compositions are prepared by using the glass frits in Examples 1 to 13 and the glass frits in Comparative example 1 to 4, are used to produce solar cells, so as to obtain corresponding Examples 14 to 26 and Comparative examples 5 to 8. Performance of finished solar cells in Examples 14 to 26 and the cells in Comparative examples 5 to 8 are evaluated, and the results are shown in Table 2.

In the conductive paste compositions in Examples 14 to 26 and Comparative examples 5 to 8, a weight percentage of the content of the glass frit is 1.5 wt %; the conductive component uses spherical silver powder with a median particle size of 2 µm, and a weight percentage of the content of the conductive component glass frit is 89.5 wt %; and a weight percentage of the content of the organic medium is 9 wt %. The organic medium specifically includes: 1.5 wt % of ethylcellulose, 1.5 wt % of polyvinyl butyraldehyde copolymer (PVB), 1.6 wt % of diethylene glycol butyl ether acetate, 0.3 wt % of silicone oil, 0.15 wt % of Duomeen TDO (non-ionic surfactant, which belongs to an amine oxide), 0.15 wt % of Brij L4 (non-ionic surfactant, which belongs to a polyoxyethylene alcohol), 0.4 wt % of Thixotrol plus (rheological agent), 2.8 wt % of diol (Ethoxylated Alcohol C12), and 0.6 wt % of dibasic acid ester. A specific preparation process of the conductive paste composition is as follows: The above components are batched, stirred and dispersed, then milled using a three-roller mill to a fineness of grind of less than 10 um, and then further filtered.

The preparation process is as follows: First, a semi-finished TOPCon solar cell (or commonly known as a blue wafer) is prepared, and four screen printers are used for the corresponding rear busbars, rear finger grid, front busbars, and front finger grids; the conductive paste composition is applied as the front finger grid on the P side; sintering the baseplate and the conductive paste composition so that the conductive paste composition etches the passivation layer during the sintering process, to obtain a conductive structure on the P side of the baseplate; and performing laser enhancement contact optimization on the conductive structure to obtain a solar cell.

The performance evaluation data show in Table 2 are measured by the following methods:
(a) Suns-Voc test:. The Suns-Voc test is performed after sintering using Sinton WCT120 tester. The measured Suns-Vocis used to characterize and compare carrier recombination performance of different conductive pastes after sintering.
(b) I-V test: A commercially available IV tester is used to the photovoltaic power conversion efficiency of the solar cell, including photovoltaic power conversion efficiency (Eff), open circuit voltage (Voc), fill factor (FF), and current (Isc). The experimental data describes the electrical performance of the examples and the comparative examples in a form of difference values, such as ΔEff, ΔVoc, ΔFF, and ΔIsc.

**Table 2**

| | Suns-Voc mV | ΔEff% | ΔVoc mV | ΔIsc mA | ΔFF% |
|---|---|---|---|---|---|
| Example 14 | 723 | 0.00 | 0.00 | 0.00 | 0.00 |
| Example 15 | 727 | 0.06 | 2.5 | -6.1 | 0.0 |
| Example 16 | 731 | 0.12 | 4.5 | 15.2 | -0.2 |
| Example 17 | 727 | 0.10 | 3.5 | 13.8 | -0.1 |
| Example 18 | 729 | -0.05 | 1.1 | -11.9 | -0.2 |
| Example 19 | 723 | -0.07 | -2.4 | -16.1 | 0.1 |
| Example 20 | 722 | -0.07 | -0.7 | -5.9 | -0.1 |
| Example 21 | 728 | 0.03 | 2.6 | -0.2 | -0.20 |
| Example 22 | 727 | 0.05 | 2.1 | 2.8 | -0.08 |
| Example 23 | 723 | -0.06 | 0.3 | -2.1 | -0.20 |
| Example 24 | 724 | -0.03 | 0.8 | 10.8 | -0.24 |
| Example 25 | 724 | -0.01 | 1.3 | 16.7 | -0.30 |
| Example 26 | 728 | 0.05 | 2.4 | 9.7 | -0.20 |
| Comparative example 5 | 719 | -0.20 | -3.9 | -14.7 | -0.13 |
| Comparative example 6 | 725 | -0.18 | 1.1 | -16.7 | -0.62 |
| Comparative example 7 | 721 | -0.33 | -2.8 | -19.2 | -0.68 |
| Comparative example 8 | 718 | -0.59 | -5.5 | -15.9 | -1.30 |

It can be learned from Table 2 that the solar cells in Examples 14 to 26 achieves ±0.1% performance difference relative to Example 14. Comparing to Comparative Examples 5 to 8, the conductive paste composition in the embodiments of this application can improve the open circuit voltage and conversion efficiency significantly by combining the low carrier recombination paste composition with laser enhancement contact improvement, which indicates that the conductive paste composition provided in this application can significantly improve the effect of metallization for the p side of the TOPCon-structured solar cell. The effects in Comparative Examples 5 and 6 are worse than those in the examples. This is because the cation ratio of (Pb+Bi)/B in the glass powder corresponding to Comparative Example 5 is too high, resulting in a loss of open voltage due to its stronger etching ability. The cation ratio of (Pb+Bi)/B in Comparative example 6 is too low resulting in a glass powder with etching ability that is too weak to obtain a good electrical contact, resulting in a large loss in FF. In addition, in Comparative Example 7 and Comparative Example 8, because the amount of TeO2 added to the glass frit is too high, glass fluidity is too strong such that excessive damage to the passivation layer is caused during sintering which results in a loss of open circuit voltage.

Examples 27 to 30 and Comparative example 9 are provided. The process for the preparation of the solar cells for Examples 27 to 30 are the same as Example 14. The difference lies within conductive paste composition for Examples 27 to 30 which further includes a filler, and the filler uses aluminum powder with a median particle size of 2 µm. Because aluminum powder is added to the conductive paste composition, of the amount of silver powder in the conductive component needs to be adjusted to ensure that an overall weight percentage is 100%. Comparative example 9 is similar to Example 27, except that the amount of aluminum powder added exceeds 1 wt %. The specific amounts and test results are shown in Table 3.

**Table 3**

| Sample | Glass frit wt % | Aluminum powder wt % | Suns-Voc mV | ΔEff % | ΔVoc mV | ΔIsc mA | ΔFF % |
|---|---|---|---|---|---|---|---|
| Example 14 | 1.5 | / | 723 | 0.00 | 0.00 | 0.00 | 0.00 |
| Example 27 | 1.5 | 0.25 | 729 | -0.02 | 1.5 | -12.7 | -0.2 |
| Example 28 | 1.5 | 0.50 | 730 | -0.07 | 3.8 | -3.7 | -0.7 |
| Example 29 | 1.5 | 0.75 | 732 | -0.24 | 2.5 | 1.8 | -1.1 |
| Example 30 | 1.5 | 1 | 731 | -0.41 | 2.7 | -10.2 | -1.6 |
| Comparative example 9 | 1.5 | 1.25 | 731 | -0.52 | 2.8 | -10.1 | -2.0 |

It may be learned from Table 3 that a small amount of aluminum powder may be added to further reduce the carrier recombination to improve open circuit voltage. The addition of aluminum powder in an amount of 0 to 1 wt % can further reduce the recombination to improve the open circuit voltage. Because aluminum oxide formed by the small amount of added aluminum powder during the high-temperature sintering process can be partly incorporated into the molten glass frit during sintering. An increase of aluminum oxide in the molten glass frit reduces the fluidity and corrosiveness of the glass melt, thereby reducing damage to the passivation layer. However, aluminum powder is not suitable to be added in large amounts because the aluminum powder can greatly reduce the fill factor, hence lowers efficiency. In Table 3, it may be learned that FF loss increases with increasing content of Al powder. Because the aluminum powder in Comparative example 9 is greater than 1 wt %, the loss in FF is too significant and cannot be compensated by the gains in open circuit voltage, resulting in large efficiency loss. The amount of aluminum oxide that can be incorporated into different glass frits melts may be different.

Example 31 and Comparative examples 10 and 11 are provided. The process for the preparation of solar cell in Example 31 is the same as Example 14. The difference lies in that the amount of the glass frit is 3 wt % in Example 31. The amount of the glass frit in Comparative example 10 is 4.5 wt % which exceeds a specified range. Comparative example 11 shows a commercially available silver-aluminum paste (containing 3 wt % to 7 wt % of glass frit, 1 wt % to 2 wt % of aluminum powder, and about 10% of organic carrier; the rest is silver powder). For the specific amount and corresponding test results, refer to Table 4.

**Table 4**

| Sample | Glass Frit Wt % | Suns-Voc mV | ΔEff % | ΔVoc mV | ΔIsc mA | ΔFF % |
|---|---|---|---|---|---|---|
| Example 14 | 1.5 | 723 | 0.00 | 0.00 | 0.00 | 0.00 |
| Example 31 | 3.0 | 723 | -0.04 | -2.9 | -0.5 | 0.2 |
| Comparative example 10 | 4.5 | 719 | -0.27 | -6.1 | -0.9 | -0.2 |
| Comparative example 11 | / | 719 | -0.35 | -5.4 | -41.7 | -0.3 |

It may be learned from Table 4 that comparing to the commercially available high-efficiency silver-aluminum paste, the conductive paste composition used in this embodiment shows the effect of significantly reduced carrier recombination as demonstrated by the Suns-Voc results in Table 4. The effect is that significant improvement of open circuit voltage and efficiency improvement of more than 0.3% can be achieved after laser enhancement contact improvement processing post sintering. It can be learned from the data in Comparative example 10 that as the amount of the glass frit increases to 4.5 wt % results in increased damage to the passivation layer as indicated by a loss of Suns-Voc. Therefore, the amount of glass frit needs to be in a range of 0.5 wt % to 4 wt %.

Further, two comparison examples prepared using the commercially available high-efficiency silver-aluminum paste. The solar preparation process for the two the two examples are same as Example 14, except for different process post sintering. For the test result, refer to Table 5.

**Table 5**

| | Process | ΔEff % | ΔVoc mV | ΔIsc mA | ΔFF % |
|---|---|---|---|---|---|
| Example 14 | Sintering + Laser enhancement contact improvement | 0 | 0 | 0 | 0 |
| Commercially available high-efficiency silver-aluminum paste | Sintering | -0.35 | -5.4 | -41.7 | -0.3 |
| | Sintering + Laser enhancement contact improvement | -0.37 | -5.8 | -43.8 | -0.3 |

It may be learned from Table 5 that solar cell prepared using commercially available high-efficiency silver-aluminum paste post sintering does not show further efficiency improvement with laser enhancement contact improvement . Therefore, it can be seen that the laser enhancement contact improvement process requires the improved conductive paste composition in this application to achieve higher solar cell conversion efficiency.

In the above-mentioned embodiments, the description of each embodiment has respective focuses. For a part that is not described in detail in an embodiment, refer to related descriptions in other embodiments.

The foregoing describes in detail the conductive paste composition, the solar cell preparation method, and the solar cell that are provided in the embodiments of this application, and the principles and implementations of this application are described by using specific examples. The foregoing embodiments and examples are merely used to help understand the technical solutions and core ideas of this application. A person of ordinary skill in the art should understand that the technical solutions described in the foregoing embodiments may be modified, or some of the technical features may be equally replaced. However, these modifications or substitutions without departing from the essence of the corresponding technical solutions fall within the scope of the application.

## Claims

1. A conductive paste composition, wherein the conductive paste composition comprises 0.5 wt % to 4 wt % of glass frit, 80 wt % to 92 wt % of conductive component, and 7 wt % to 16 wt % of organic medium in terms of a weight percentage of the conductive paste composition;
wherein the glass frit comprises oxides, and in terms of mole percentages of the oxides, the glass frit comprises 20 mol % to 50 mol % of B₂O₃, and the glass frit further comprises 15 mol % to 50 mol % of PbO, or 15 mol % to 50 mol % of Bi₂O₃, or 15 mol % to 50 mol % of a mixture of PbO and Bi₂O₃; and
wherein a ratio of a sum of the cation content of PbO and Bi₂O₃ to the cation content of B₂O₃ is 0.30 to 1.25.

2. The conductive paste composition according to claim 1, wherein in terms of the mole percentages of the oxides, the glass frit further comprises a first additive, a content of the first additive is less than or equal to 18 mol %, and the first additive is any one or more selected from Li₂O, Al₂O₃, ZnO, SiO₂, SeO₂ and TeO₂.

3. The conductive paste composition according to claim 2, wherein in terms of the mole percentages of the oxides, the first additive satisfies at least one of the following conditions:
(a) the first additive comprises Li₂O, and a content of the Li₂O is less than or equal to 15 mol %;
(b) the first additive comprises Al₂O₃, and a content of the Al₂O₃ is less than or equal to 10 mol %;
(c) the first additive comprises ZnO, and a content of the ZnO is less than or equal to 18 mol %;
(d) the first additive comprises SiO₂, and a content of the SiO₂ is less than or equal to 15 mol %;
(e) the first additive comprises SeO₂, and a content of the SeO₂ is less than or equal to 15 mol %; or
(f) the first additive comprises TeO₂, and a content of the TeO₂ is less than or equal to 15 mol %.

4. The conductive paste composition according to claim 1, wherein the glass frit further comprises 0 to 15 mol % of Li₂O, 0 to 10 mol % of Al₂O₃, 0 to 18 mol % of ZnO, and 0 to 15 mol % of SiO₂ in terms of the mole percentages of the oxides.

5. The conductive paste composition according to claim 1, wherein the glass frit further comprises a second additive, a content of the second additive is less than or equal to 5 mol %, in terms of the mole percentages of the oxides, and the second additive is selected from any one or more of AgO₂, Ag₂O, AgO, Na₂O, K₂O, MgO, CaO, and BaO.

6. The conductive paste composition according to claim 1, wherein the conductive paste composition further includes a filler less than or equal to 1 wt % in terms of the weight percentage of the composition, and the filler comprises at least one of aluminum powder, silicon powder, or aluminum-silicon alloy powder.

7. The conductive paste composition according to claim 6, wherein a weight percentage of the filler in the conductive paste composition is greater than 0 and less than or equal to 1 wt %.

8. The conductive paste composition according to claim 6, wherein Dᵥ50 of the filler is 1 µm to 4 µm, Dᵥ50 is the corresponding particle size in case where the cumulative volume percentage of the filler reaches 50%.

9. The conductive paste composition according to claim 1, wherein the conductive component is any one selected from silver, silver alloy, silver oxide, and silver salt, or a mixture of the combinations thereof.

10. The conductive paste composition according to claim 1, wherein a first conductive structure (20) is formed on a solar cell, the solar cell comprises a substrate (101) and a passivation layer (103) at least located on one side of the substrate (101), and during the process the solar cell is sintered, the conductive paste composition penetrates the passivation layer (103) to form the first conductive structure (20).

11. The conductive paste composition according to claim 10, wherein the substrate (101) comprises an n-type doped semiconductor substrate.

12. A solar cell preparation method, comprising the following steps:
providing a baseplate (10), wherein the baseplate (10) comprises a substrate (101), a p-type doped layer (102), and a passivation layer (103), and the p-type doped layer (102) is located between the substrate (101) and the passivation layer (103);
applying the conductive paste composition according to any one of claims 1-11 onto the passivation layer (103);
sintering the baseplate (10) covered with the conductive paste composition, so that the conductive paste composition etches the passivation layer (103) to form a first conductive structure (20); and
performing laser enhancement contact optimization on the baseplate (10) to obtain the solar cell.

13. The solar cell preparation method according to claim 12, wherein the step of applying the conductive paste composition onto the passivation layer (103) comprises:
applying the conductive paste composition to at least a part of a surface of the passivation layer (103) in a patterned form.

14. The solar cell preparation method according to claim 12, wherein the step of performing laser enhancement contact optimization on the baseplate (10) comprises:
applying a reverse voltage to the baseplate (10), and simultaneously performing laser scanning on the baseplate (10), to generate induced current in the first conductive structure (20).

15. The solar cell preparation method according to claim 14, wherein the preparation method meets at least one of the following conditions:
(g) the solar cell has a breakdown voltage, and the reverse voltage is less than the breakdown voltage;
(h) the laser scanning lasts for 1 ms to 100 ms; or
(i) the induced current is 100 A to 1000 A.

16. A solar cell comprising a first conductive structure (20) made of the conductive paste composition according to any one of claims 1-11.

17. A solar cell, wherein the solar cell is prepared by using the preparation method according to any one of claims 12-15.

18. The solar cell according to any one of claims 16-17, wherein the solar cell is a solar cell comprising a tunnel oxide passivated contact structure.
